# EUROPEAN PATENT APPLICATION

(11) **EP 4 718 503 A1**
(43) Date of publication of application: **01.04.2026**
(21) Application number: 24810708.8
(22) Date of filing: 27.03.2024
(51) Int. Cl.: H01L 27/146

(54) **OPTICAL PACKAGE AND METHOD FOR MANUFACTURING OPTICAL PACKAGE**

(30) Priority: 22.05.2023 JP 2023083599
(71) Applicant: Sony Semiconductor Solutions Corporation, Atsugi-shi, Kanagawa 243-0014 (JP)
(72) Inventor: WAKABAYASHI, Takahiro, Kikuchi-gun, Kumamoto 869-1102 (JP); TAGUCHI, Kenichi, Kikuchi-gun, Kumamoto 869-1102 (JP)
(74) Representative: MFG Patentanwälte Meyer-Wildhagen Meggle-Freund Gerhard PartG mbB
(86) International application number: PCT/JP2024/012422
(87) International publication number: WO 2024/241700

(57) **Abstract**

The present disclosure enables hermetic sealing of an optical package while relaxing restrictions on an optical path. An optical package includes a substrate, an optical element mounted on the substrate, a transparent member disposed above the optical element, spaced apart from the optical element, a frame member fixed to the transparent member, and a bonding member fixed to the substrate and bonded to the frame member. Part of a bonding position between the frame member and the bonding member is located outward of an outer periphery of the substrate. The optical package may further include a welded portion provided at the bonding position between the frame member and the bonding member. The optical package may further include a buffer member provided in a frame-like shape between the frame member and the transparent member. An outer size of the buffer member may be larger than an outer size of the substrate. A material of the frame member and a material of the bonding member may be metal.

## Description

### Technical Field

The present technology relates to an optical package and a method for manufacturing the optical package. More particularly, the present invention relates to an optical package in which an optical element is hermetically sealed, and a method for manufacturing the optical package.

### Background Art

An optical package may be hermetically sealed to prevent entry of outside air. For example, a sensor device has been proposed in which a lid with seal glass is attached to an upper surface side of a sensor assembly optical package to hermetically seal the optical package (refer to PTL 1, for example).

### Citation List

### Patent Literature

PTL 1: WO 2020/202789

### Summary

### Technical Problem

However, in the related art described above, an end portion of the lid with seal glass is located inside an optical package substrate. As a result, there is a possibility of an increase in restrictions on an incident angle by the lid with seal glass.

The present technology has been made in view of such circumstances, and an object thereof is to enable hermetic sealing of an optical package while relaxing restrictions on an optical path.

### Solution to Problem

The present technology has been made to solve the problem described above, and a first aspect thereof is an optical package including a substrate, an optical element mounted on the substrate, a transparent member disposed above the optical element, spaced apart from the optical element, a frame member fixed to the transparent member, and a bonding member fixed to the substrate and bonded to the frame member. Part of a bonding position between the frame member and the bonding member is located outward of an outer periphery of the substrate. According to this configuration, an effect of increasing a distance between an optical path of the optical element and the bonding member while hermetically sealing the optical element is achieved.

Further, in the first aspect, the optical package may further include a welded portion provided at the bonding position between the frame member and the bonding member. According to this configuration, an effect of bonding the frame member and the bonding member to each other while ensuring a hermeticity of the optical package is achieved.

Further, in the first aspect, a material of the frame member and a material of the bonding member may be metal. According to this configuration, an effect of bonding the frame member and the bonding member to each other on the basis of seam welding is achieved.

Further, in the first aspect, the bonding member may have a flat plate-like shape. According to this configuration, an effect of reducing a height of the optical package is achieved.

Further, in the first aspect, the substrate may include a cavity configured to accommodate the optical element. According to this configuration, an effect of reducing a height difference of a bonding wire connecting the substrate and the optical element is achieved.

Further, in the first aspect, the bonding member may have a frame-like shape. According to this configuration, an effect of disposing the bonding member around a periphery of the substrate on which the optical element is mounted is achieved.

Further, in the first aspect, the bonding member may be disposed on a lower surface of the substrate. According to this configuration, an effect of disposing the bonding member on the substrate without affecting a mounting region of the optical element is achieved.

Further, in the first aspect, the frame member may be disposed spaced apart from the optical element such that part of a side surface of the frame member faces a side surface of the optical element. According to this configuration, an effect of relaxing restrictions on the optical path of the optical element by the frame member is achieved.

Further, in the first aspect, the optical element may be an image sensor. According to this configuration, an effect of generating an imaged image while enlarging a viewing angle is achieved.

Further, in the first aspect, the optical package may further include a Peltier element provided between the substrate and the optical element. According to this configuration, an effect of cooling the optical element is achieved.

Further, in the first aspect, the frame member may be disposed from a bonding surface with the transparent member to a bonding surface with the bonding member. According to this configuration, an effect of bonding the frame member and the bonding member to each other without interposing a buffer member between the frame member and the transparent member is achieved.

Further, in the first aspect, the optical package may further include a buffer member provided in a frame-like shape between the frame member and the transparent member. According to this configuration, an effect of absorbing damage extending to the transparent member during bonding of the frame member fixed to the transparent member and the bonding member is achieved.

Further, in the first aspect, the buffer member may be a ceramic frame. According to this configuration, an effect of fixing the frame member to the transparent member while improving a compatibility between the transparent member and the buffer member is achieved.

Further, in the first aspect, the frame member may be disposed on a lower surface of the buffer member. According to this configuration, an effect of disposing the buffer member between the frame member fixed to the transparent member and the bonding member is achieved.

Further, in the first aspect, the frame member may be disposed at a center of a lower surface of the buffer member. According to this configuration, an effect of improving a stability of the buffer member on the frame member is achieved.

Further, in the first aspect, an outer size of the buffer member may be larger than an outer size of the substrate. According to this configuration, an effect of relaxing restrictions on the optical path of the optical element by the buffer member is achieved.

Further, in the first aspect, the buffer member may be disposed spaced apart from the optical element such that part of a side surface of the buffer member faces a side surface of the optical element. According to this configuration, an effect of disposing the buffer member around a periphery of the optical element is achieved.

Further, in a second aspect, a method for manufacturing an optical package includes mounting an optical element on a substrate provided with a bonding member at a position protruding from a periphery of the substrate, and bonding a frame member provided along a periphery of a transparent member to the bonding member and disposing the transparent member above the optical element, spaced apart from the optical element. According to this configuration, an effect of hermetically sealing the optical element while increasing the distance between the optical path of the optical element and the bonding member is achieved.

Further, in the second aspect, a buffer member provided in a frame-like shape may be interposed between the frame member and the transparent member. According to this configuration, an effect of bonding the frame member fixed to the transparent member and the bonding member to each other while reducing damage extending to the transparent member is achieved.

Further, in the second aspect, the frame member may be bonded to the bonding member on the basis of seam welding. According to this configuration, an effect of improving the hermeticity of the optical package while increasing the distance between the optical path of the optical element and the bonding member is achieved.

### [Brief Description of Drawings]

[Fig. 1]

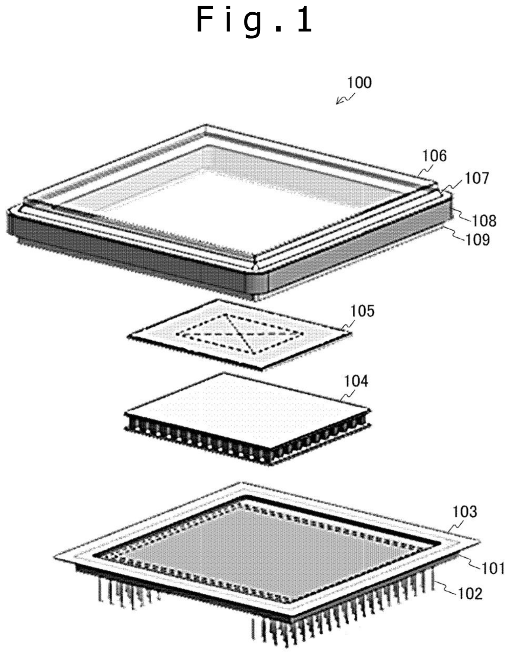

   Fig. 1 is an exploded perspective view depicting a configuration example of an optical package according to a first embodiment.
[Fig. 2]

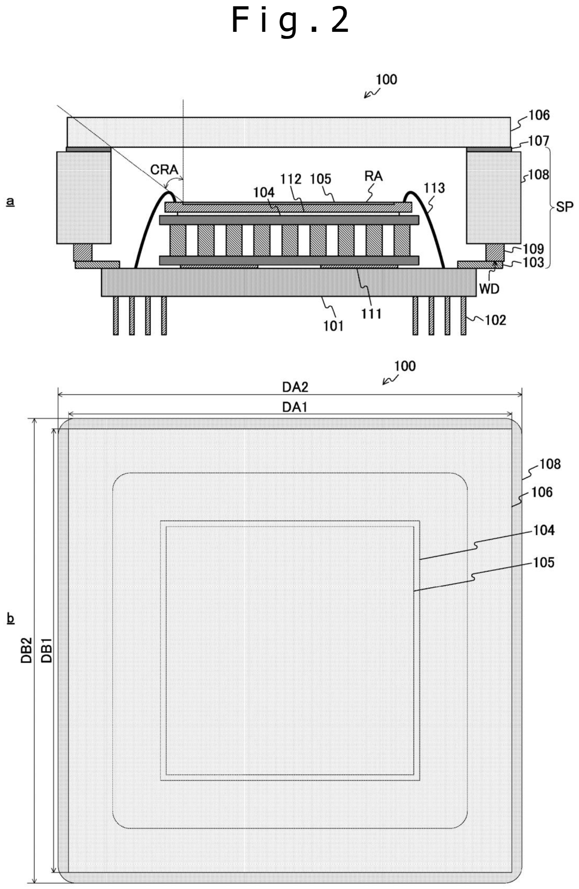

   Fig. 2 is a diagram depicting the configuration example of the optical package according to the first embodiment.
[Fig. 3]

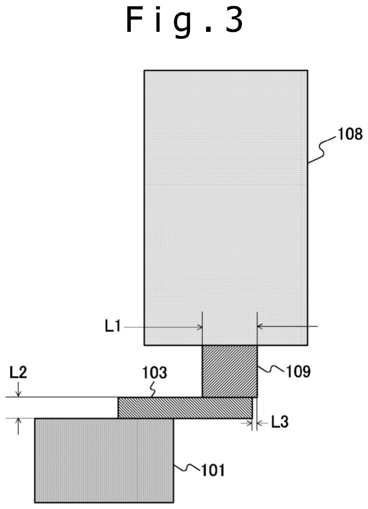

   Fig. 3 is an enlarged cross-sectional view of a portion of a frame member, a bonding member, and a buffer member of the optical package according to the first embodiment.
[Fig. 4]

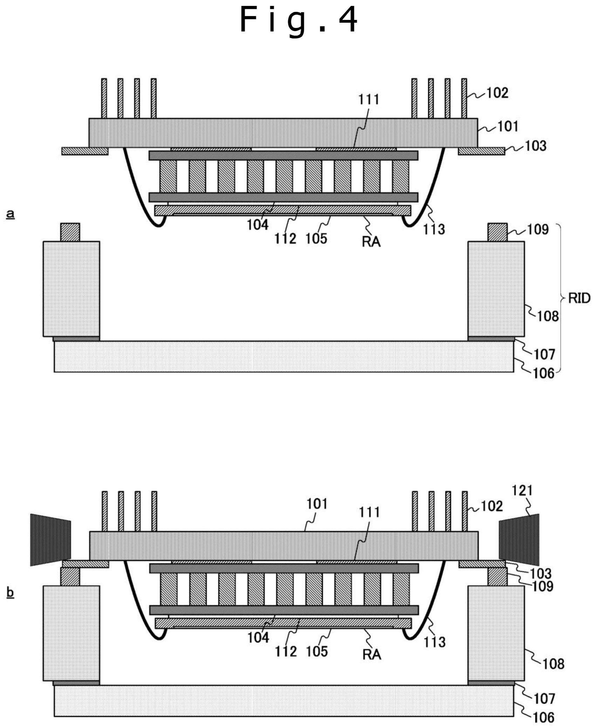

   Fig. 4 is a cross-sectional view depicting an example of a method for manufacturing the optical package according to the first embodiment.
[Fig. 5]

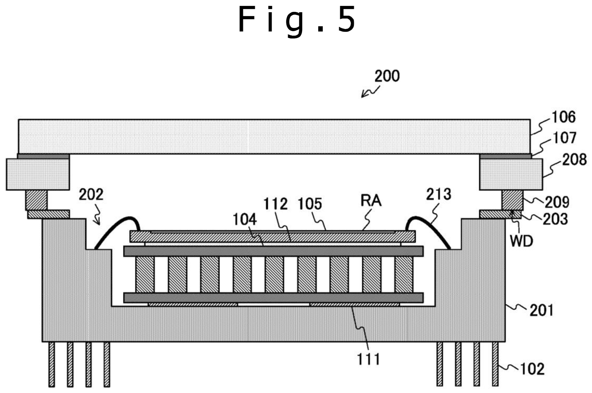

   Fig. 5 is a cross-sectional view depicting a configuration example of an optical package according to a second embodiment.
[Fig. 6]

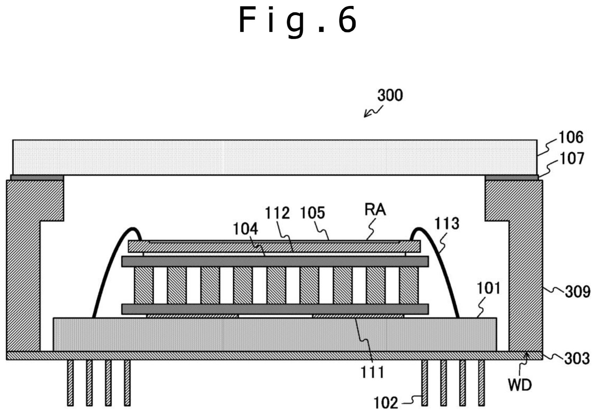

   Fig. 6 is a cross-sectional view depicting a configuration example of an optical package according to a third embodiment.
[Fig. 7]

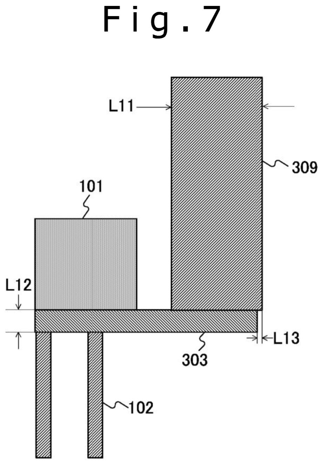

   Fig. 7 is an enlarged cross-sectional view of a portion of a frame member and a bonding member of the optical package according to the third embodiment.
[Fig. 8]

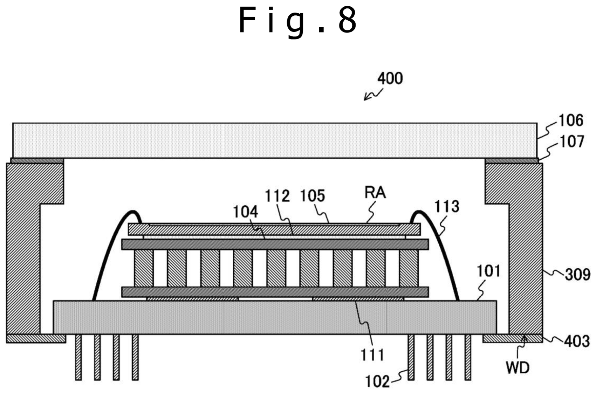

   Fig. 8 is a cross-sectional view depicting a configuration example of an optical package according to a fourth embodiment.
[Fig. 9]

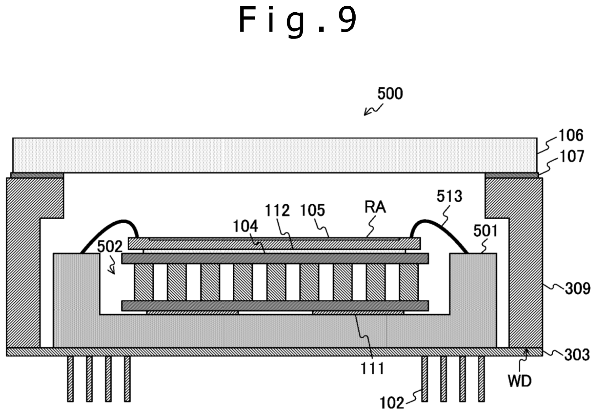

   Fig. 9 is a cross-sectional view depicting a configuration example of an optical package according to a fifth embodiment.
[Fig. 10]

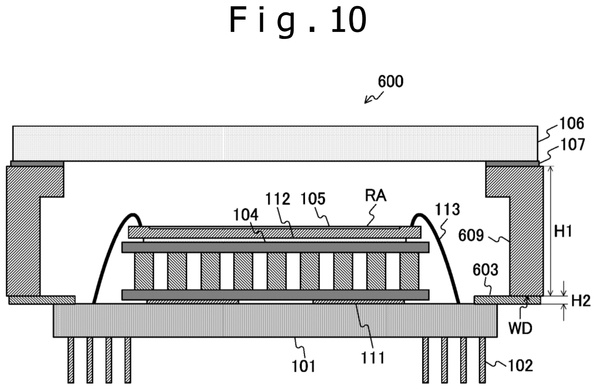

   Fig. 10 is a cross-sectional view depicting a configuration example of an optical package according to a sixth embodiment.
[Fig. 11]

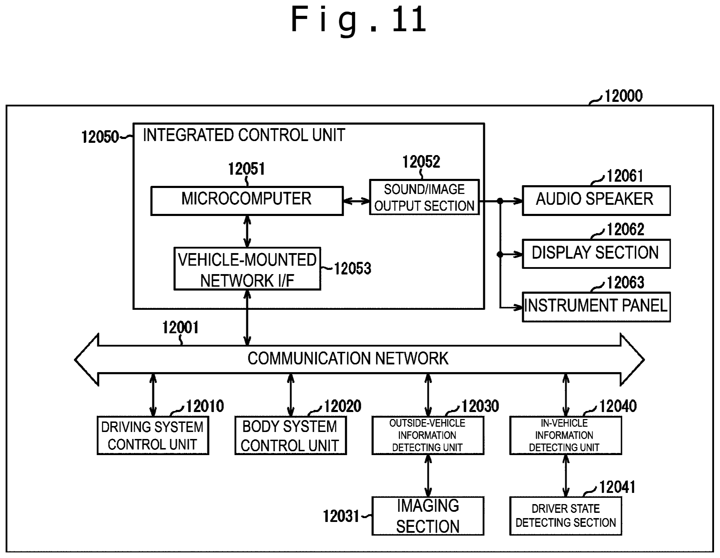

   Fig. 11 is a block diagram depicting a schematic configuration example of a vehicle control system.
[Fig. 12]

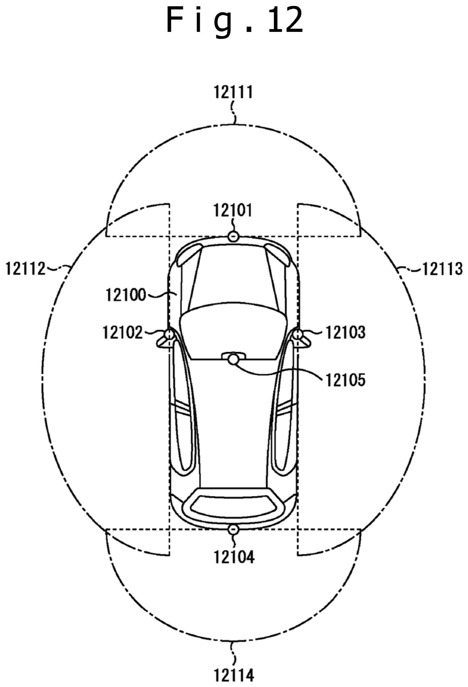

   Fig. 12 is an explanatory view depicting an example of an installation position of an imaging section.

### Description of Embodiments

Hereinafter, modes for carrying out the present technology (hereinafter, referred to as embodiments) will be described. Description will be made in the following order.
1. First Embodiment (example in which a buffer member having an outer size larger than an outer size of a mounting substrate is provided between a frame member, which is bonded to a bonding member at a position protruding from a periphery of the mounting substrate, and a glass substrate)
2. Second Embodiment (example in which a buffer member having an outer size larger than an outer size of a mounting substrate is provided between a frame member, which is bonded to a bonding member at a position protruding from a periphery of the mounting substrate, and the glass substrate, the mounting substrate being formed with a cavity that can accommodate an image sensor)
3. Third Embodiment (example in which a frame member bonded to a bonding member at a position protruding from the periphery of the mounting substrate is disposed from the bonding surface with the glass substrate to a bonding surface with the bonding member, and the bonding member having a flat plate-like shape is provided on a back surface of the mounting substrate)
4. Fourth Embodiment (example in which the frame member bonded to a bonding member at a position protruding from the periphery of the mounting substrate is disposed from the bonding surface with the glass substrate to a bonding surface with the bonding member, and the bonding member having a frame-like shape is provided on the back surface of the mounting substrate)
5. Fifth Embodiment (example in which the frame member bonded to the bonding member at a position protruding from a periphery of a mounting substrate is disposed from the bonding surface with the glass substrate to the bonding surface with the bonding member, the mounting substrate being formed with a cavity that can accommodate the image sensor)
6. Sixth Embodiment (example in which a frame member bonded to a bonding member at a position protruding from the periphery of the mounting substrate is disposed from the bonding surface with the glass substrate to a bonding surface with the bonding member, and the bonding member having a frame-like shape is provided on the mounting substrate)
7. Application Example of Mobile Body

### 1. First Embodiment

Fig. 1 is an exploded perspective view depicting a configuration example of an optical package according to a first embodiment, and Fig. 2 is a diagram depicting the configuration example of the optical package according to the first embodiment. Note that a in Fig. 2 is a cross-sectional view depicting the configuration example of the optical package according to the first embodiment, and b of Fig. 2 is a plan view depicting the configuration example of the optical package according to the first embodiment. The drawings used in the following descriptions may differ in scale, shape, and the like from the actual structure for ease of understanding of the configurations.

In the drawings, an optical package 100 hermetically seals an optical element. The optical package 100 includes a mounting substrate 101, a glass substrate 106, and a support member SP. The glass substrate 106 is supported on the mounting substrate 101 by the support member SP so as to be spaced apart from the mounting substrate 101.

An image sensor 105 is mounted as an optical element on the mounting substrate 101. In such a case, to cool the image sensor 105, the image sensor 105 may be mounted on the mounting substrate 101 with a Peltier element 104 interposed therebetween. By cooling the image sensor 105, it is possible to reduce a dark current of the image sensor 105 and improve an image quality. A pin grid array (PGA) may be used as the mounting substrate 101, for example. A multilayer substrate may be on the mounting substrate 101. A shape of the mounting substrate 101 may be a flat plate-like shape. Here, the mounting substrate 101 is formed in a flat plate-like shape, making it possible to reduce a height of the optical package 100.

A base material of the mounting substrate 101 is, for example, ceramic. The mounting substrate 101 is formed with a wiring line and a bonding pad. A through electrode or the like may be formed on the mounting substrate 101. A lead terminal 102 is formed on a back surface side of the mounting substrate 101. A material of the lead terminal 102 may be an Fe-Ni-Co alloy or may be a metal such as Cu, for example. A plating layer of Ni, Au, or the like may be formed on the lead terminal 102. Note that the mounting substrate 101 is an example of a substrate described in the claims.

The image sensor 105 is provided with a pixel region RA. In the pixel region RA, pixels are disposed in a matrix in a row direction and a column direction. The wiring line, the bonding pad, and the like can be formed around a periphery of the pixel region RA. The image sensor 105 is connected to the mounting substrate 101 via a bonding wire 113. As a material of the bonding wire 113, a metal such as Au or Al can be used. The image sensor 105 may be sensitive to visible light, may be sensitive to near infrared (NIR) light, may be sensitive to short wavelength infrared (SWIR) light, or may be sensitive to ultraviolet light, X-rays, or the like. A substrate material of the image sensor 105 can be selected from semiconductors such as Si, GaAs, InGaAs, and InGaAsP, for example. Note that the image sensor 105 is an example of an optical element described in the claims.

The Peltier element 104 is disposed between the mounting substrate 101 and the image sensor 105. The Peltier element 104 cools the image sensor 105 on the basis of the Peltier effect. The image sensor 105 can be mounted on a cooling substrate of the Peltier element 104 with a die bond material 112 interposed therebetween. A material of the die bond material 112 may be a paste material containing a metal such as Ag, or may be a resin such as epoxy. The Peltier element 104 is mounted on the mounting substrate 101 with a drive electrode 111 that drives the Peltier element 104 interposed therebetween. Note that the Peltier element 104 may be omitted. In such a case, the image sensor 105 can be directly mounted on the mounting substrate 101.

The support member SP supports the glass substrate 106 on the mounting substrate 101 such that the glass substrate 106 is spaced apart from the image sensor 105. The support member SP is fixed to the mounting substrate 101 at a position protruding from a periphery of the mounting substrate 101. The support member SP includes a bonding member 103, a buffer member 108, and a frame member 109.

The bonding member 103 is fixed on the mounting substrate 101 and bonded to the frame member 109. A fixed position of the bonding member 103 on the mounting substrate 101 can be set outside of the bonding pad on the mounting substrate 101. Here, the bonding member 103 can be bonded to the frame member 109 at a position protruding from the periphery of the mounting substrate 101. In such a case, the bonding member 103 can be continuously formed in a frame-like shape along the periphery of the mounting substrate 101. A thickness of the bonding member 103 can be set to be constant.

A material of the bonding member 103 can be a metal. For example, the material of the bonding member 103 may be an Fe-Ni-Co alloy. In such a case, a plating layer of Ni, Au, or the like may be formed on a front surface of the Fe-Ni-Co alloy. The bonding member 103 may be a seam welding ring. In such a case, an inner peripheral side of the bonding member 103 can be fixed on the mounting substrate 101, and an outer peripheral side of the bonding member 103 can protrude from the periphery of the mounting substrate 101. On the outer peripheral side of the bonding member 103, a back surface of the bonding member 103 can be exposed from the mounting substrate 101. For example, an Au-Cu brazing filler material can be used to bond the bonding member 103 and the mounting substrate 101 to each other.

The frame member 109 is disposed between the bonding member 103 and the buffer member 108. In such a case, a lower surface of the frame member 109 is bonded to the bonding member 103, and an upper surface of the frame member 109 is bonded to the buffer member 108. In such a case, part of a bonding position between the frame member 109 and the bonding member 103 is located outward of an outer periphery of the mounting substrate 101. A width of the frame member 109 can be smaller than a width of the buffer member 108. In such a case, the frame member 109 can be bonded to a center of a lower surface of the buffer member 108. The frame member 109 can be continuously formed in a frame-like shape along a periphery of the bonding member 103. A thickness of the frame member 109 can be set to be constant.

A material of the frame member 109 may be the same as the material of the bonding member 103. In such a case, a metal can be used as the material of the frame member 109. For example, the material of the frame member 109 may be an Fe-Ni-Co alloy. In such a case, a plating layer of Ni, Au, or the like may be formed on a front surface of the Fe-Ni-Co alloy. The frame member 109 and the bonding member 103 can be bonded by using seam welding. In such a case, a welded portion WD can be provided at the bonding position between the frame member 109 and the bonding member 103. The frame member 109 can constitute a lid for seam welding together with the glass substrate 106 and the buffer member 108.

The buffer member 108 is disposed between the frame member 109 and the glass substrate 106. In such a case, the lower surface of the buffer member 108 is bonded to the frame member 109, and an upper surface of the buffer member 108 is bonded to the glass substrate 106 via an adhesive layer 107. As a material of the adhesive layer 107, low-melting-point glass can be used, for example. For bonding the buffer member 108 and the frame member 109 to each other, an Au-Cu brazing filler material can be used, for example. The buffer member 108 can be continuously formed in a frame-like shape along the frame member 109. Here, the buffer member 108 can be disposed spaced apart from the image sensor 105 such that a portion of a side surface of the buffer member 108 faces a side surface of the image sensor 105. In such a case, an inner peripheral surface of the buffer member 108 can be located outside the bonding wire 113. A thickness of the buffer member 108 can be set to be constant. A corner of the side surface of the buffer member 108 may have a finite curvature. In this case, a planar shape of the corner of the side surface of the buffer member 108 may be an arc shape.

A material of the buffer member 108 is preferably a material that is more excellent in toughness than the glass substrate 106 and has a thermal expansion coefficient close to that of the glass substrate 106. For example, the buffer member 108 may be a ceramic frame. This makes it possible to absorb damage extending to the glass substrate 106 during seam welding of the frame member 109 and the bonding member 103 by the buffer member 108 and prevent cracking of the glass substrate 106.

Outer sizes DA2 and DB2 of the buffer member 108 are preferably larger than outer sizes DA1 and DB1 of the glass substrate 106. In such a case, the buffer member 108 can be disposed spaced apart from the image sensor 105 such that part of the side surface of the buffer member 108 faces the side surface of the image sensor 105. This makes it possible to prevent light incident on the pixel region RA from being blocked by the buffer member 108 on the pixel region RA. This then makes it possible to increase a chief ray angle (CRA) and increase a viewing angle of the image sensor 105. Note that the CRA can be set to 28°< CRA < 64°.

Fig. 3 is an enlarged cross-sectional view of a portion of the frame member, the bonding member, and the buffer member of the optical package according to the first embodiment.

In the drawing, preferably a width L1 of the frame member 109 is set to 1 mm or greater. A thickness L2 of the bonding member 103 is preferably set within a range of from 0.05 to 0.10 mm. A clearance L3 is preferably provided between the frame member 109 and the bonding member 103. The clearance L3 can be set to 0.05 mm, for example. By providing the clearance L3 between the frame member 109 and the bonding member 103, it is possible to receive an inclined surface of a roller used for seam welding at the position of the clearance L3 and improve an efficiency of seam welding.

Fig. 4 is a cross-sectional view depicting an example of a method for manufacturing the optical package according to the first embodiment.

In a of the drawing, the frame member 109 is fixed to the glass substrate 106 with the buffer member 108 interposed therebetween, thereby forming a lid RID for seam welding.

On the other hand, the bonding member 103 is fixed on the mounting substrate 101. Further, the image sensor 105 is mounted on the mounting substrate 101 with the Peltier element 104 interposed therebetween, and subsequently the image sensor 105 and the mounting substrate 101 are connected via the bonding wire 113.

Then, the lid RID for seam welding is positioned such that the frame member 109 faces the bonding member 103.

Next, as depicted in b of the drawing, the frame member 109 is brought into contact with the bonding member 103. Then, a roller electrode 121 is brought into contact with the bonding member 103, and the roller electrode 121 is energized while being rotated, thereby causing the bonding member 103 to generate heat along a travel path of the roller electrode 121. Then, a bonding surface between the bonding member 103 and the frame member 109 is melted, and subsequently a molten portion is solidified on the basis of natural cooling of the bonding surface between the bonding member 103 and the frame member 109, whereby the bonding member 103 and the frame member 109 are seamwelded. Thus, the lid RID for seam welding is mounted on the mounting substrate 101, and the inside of the optical package 100 is hermetically sealed.

Thus, in the first embodiment described above, the buffer member 108 is provided between the frame member 109, which is bonded to the bonding member 103 at a position protruding from the periphery of the mounting substrate 101, and the glass substrate 106. This makes it possible to absorb, in the buffer member 108, damage extending to the glass substrate 106 during welding of the frame member 109 and the bonding member 103. As a result, it is possible to hermetically seal the inside of the optical package 100 while preventing cracking of the glass substrate 106 and to increase the CRA.

### 2. Second Embodiment

In the first embodiment described above, the buffer member 108 is provided between the frame member 109, which is bonded to the bonding member 103 at a position protruding from the periphery of the mounting substrate 101, and the glass substrate 106. In this second embodiment, a buffer member is provided between a frame member, which is bonded to a bonding member at a position protruding from a periphery of a mounting substrate, and the glass substrate 106, the mounting substrate being formed with a cavity that can accommodate the image sensor 105.

Fig. 5 is a cross-sectional view depicting a configuration example of an optical package according to the second embodiment.

In the drawing, an optical package 200 includes a mounting substrate 201, a bonding member 203, a buffer member 208, and a frame member 209, instead of the mounting substrate 101, the bonding member 103, the buffer member 108, and the frame member 109 of the first embodiment described above. Other configurations of the optical package 200 of the second embodiment are similar to the configurations of the optical package 100 of the first embodiment described above.

The mounting substrate 201 is provided with a cavity 202. The image sensor 105 is mounted inside the cavity 202 with the Peltier element 104 interposed therebetween. The image sensor 105 is connected to the mounting substrate 201 via a bonding wire 213. The cavity 202 may be provided with a step. In such a case, a bonding pad connected with the bonding wire 213 may be formed on a lower tier of the step, and the bonding surface bonded with the bonding member 203 may be formed on an upper tier of the step. In such a case, the bonding wire 213 can be kept away from a heat dissipation substrate of the Peltier element 104 by connecting the bonding wire 213 to the step of the mounting substrate 201. This makes it possible to help prevent heat dissipated through the Peltier element 104 from flowing back to the image sensor 105 via the bonding wire 213, and suppress a decrease in a cooling efficiency of the image sensor 105. The lead terminal 102 is formed on a back surface side of the mounting substrate 201.

The bonding member 203 is fixed on the mounting substrate 201 and bonded to the frame member 209. A fixed position of the bonding member 203 on the mounting substrate 201 can be set outside the cavity 202. Here, the bonding member 203 can be bonded to the frame member 209 at a position protruding from a periphery of the mounting substrate 201. In such a case, the bonding member 203 can be continuously formed in a frame-like shape along the periphery of the mounting substrate 201.

The frame member 209 is disposed between the bonding member 203 and the buffer member 208. In such a case, a lower surface of the frame member 209 is bonded to the bonding member 203, and an upper surface of the frame member 209 is bonded to the buffer member 208. The frame member 209 can be continuously formed in a frame-like shape along a periphery of the bonding member 203. In such a case, the welded portion WD can be provided at a bonding position between the frame member 209 and the bonding member 203.

The buffer member 208 is disposed between the frame member 209 and the glass substrate 106. In such a case, a lower surface of the buffer member 208 is bonded to the frame member 209, and an upper surface of the buffer member 208 is bonded to the glass substrate 106 via the adhesive layer 107. The buffer member 208 can be continuously formed in a frame-like shape along the frame member 209. An outer size of the buffer member 208 is preferably larger than an outer size of the glass substrate 106.

Thus, in the second embodiment described above, the buffer member 208 is provided between the frame member 209, which is bonded to the bonding member 203 at a position protruding from the periphery of the mounting substrate 201, and the glass substrate 106, the mounting substrate 201 being formed with the cavity 202 that can accommodate the image sensor 105. This makes it possible to hermetically seal the inside of the optical package 200 while preventing cracking of the glass substrate 106 and to increase the CRA. Here, by providing the cavity 202 in the mounting substrate 201, it is possible to reduce a height difference of the bonding wire 213 between the image sensor 105 and the mounting substrate 201.

### 3. Third Embodiment

In the first embodiment described above, the buffer member 108 is provided between the frame member 109, which is bonded to the bonding member 103 at a position protruding from the periphery of the mounting substrate 101, and the glass substrate 106. In this third embodiment, a frame member bonded to a bonding member having a flat plate-like shape and provided on a back surface of the mounting substrate 101 so as to protrude from the periphery of the mounting substrate 101 is disposed from the bonding surface with the glass substrate 106 to a bonding surface with the bonding member.

Fig. 6 is a cross-sectional view depicting a configuration example of an optical package according to the third embodiment.

In the drawing, an optical package 300 includes a bonding member 303 and a frame member 309 instead of the bonding member 103 and the frame member 109 of the first embodiment described above. Further, in the optical package 300, the buffer member 108 is omitted from the optical package 100 of the first embodiment described above. Other configurations of the optical package 300 of the third embodiment are similar to the configurations of the optical package 100 of the first embodiment described above.

The bonding member 303 is fixed on the back surface of the mounting substrate 101 and bonded to the frame member 309. The bonding member 303 can be bonded to the frame member 309 at a position protruding from the periphery of the mounting substrate 101. Here, the bonding member 303 can be configured in a flat plate-like shape so as to protrude from the periphery of the mounting substrate 101. In such a case, a front surface of an outer edge portion of the bonding member 303 can be exposed from the mounting substrate 101. Here, by providing the bonding member 303 having a flat plate-like shape on the back surface of the mounting substrate 101, it is possible to cover the back surface of the mounting substrate 101 with metal and improve a hermeticity of the optical package 300. The lead terminal 102 can penetrate the bonding member 303 and protrude to the outside. In such a case, an insulating layer can be provided between the lead terminal 102 and the bonding member 303.

The frame member 309 is disposed between the bonding member 303 and the glass substrate 106. The frame member 309 can be disposed from the bonding surface with the glass substrate 106 to the bonding surface with the bonding member 303. In such a case, a lower surface of the frame member 309 is bonded to the bonding member 303, and an upper surface of the frame member 309 is bonded to the glass substrate 106 via the adhesive layer 107. The frame member 309 can be continuously formed in a frame-like shape along a periphery of the bonding member 303. In such a case, the frame member 309 can be disposed spaced apart from the image sensor 105 such that a portion of a side surface of the frame member 309 faces the side surface of the image sensor 105. The welded portion WD can be provided at a bonding position between the frame member 309 and the bonding member 303. A step may be formed on an inner peripheral surface of the frame member 309 to increase a bonding area with the glass substrate 106. To increase the CRA of the optical package 300, the inner peripheral surface of the frame member 309 need not include a step.

Fig. 7 is an enlarged cross-sectional view of a portion of the frame member and the bonding member of the optical package according to the third embodiment.

In the drawing, preferably a width L11 of the frame member 309 is set to 1 mm or greater. A thickness L12 of the bonding member 303 is preferably set within a range of from 0.05 to 0.10 mm. A clearance L13 is preferably provided between the frame member 309 and the bonding member 303. The clearance L13 can be set to 0.05 mm, for example.

Thus, in the third embodiment described above, the frame member 309 bonded to the bonding member 303 provided on the back surface of the mounting substrate 101 so as to protrude from the periphery of the mounting substrate 101 is disposed from the bonding surface with the glass substrate 106 to the bonding surface with the bonding member 303. This makes it possible to hermetically seal the inside of the optical package 300 while preventing cracking of the glass substrate 106 and to increase the CRA. In such a case, the frame member 309 is disposed from the bonding surface with the glass substrate 106 to the bonding surface with the bonding member 303, making it possible to increase a distance between the glass substrate 106 and the welded portion WD. This makes it possible to reduce damage extending to the glass substrate 106 during welding of the frame member 309 and the bonding member 303 while omitting the buffer member 108 between the glass substrate 106 and the frame member 309. In such a case, an area of the optical package 300 surrounded by metal can be increased and the hermeticity of the optical package 300 can be improved as compared with a case in which the buffer member 108 is provided.

Further, by disposing the frame member 309 from the bonding surface with the glass substrate 106 to the bonding surface with the bonding member 303, it is possible to efficiently release heat radiated through the Peltier element 104 from the frame member 309 to the outside. This makes it possible to help prevent heat dissipated through the Peltier element 104 from flowing back to the image sensor 105 via the bonding wire 113, and suppress a decrease in the cooling efficiency of the image sensor 105.

### 4. Fourth Embodiment

In the third embodiment described above, the frame member 309 bonded to the bonding member 303 having a flat plate-like shape and provided on the back surface of the mounting substrate 101 so as to protrude from the periphery of the mounting substrate 101 is disposed from the bonding surface with the glass substrate 106 to the bonding surface with the bonding member 303. In this fourth embodiment, the frame member 309 bonded to a bonding member having a frame-like shape and provided on the back surface of the mounting substrate 101 so as to protrude from the periphery of the mounting substrate 101 is disposed from the bonding surface with the glass substrate 106 to a bonding surface with the bonding member.

Fig. 8 is a cross-sectional view depicting a configuration example of an optical package according to the fourth embodiment.

In the drawing, an optical package 400 includes a bonding member 403 instead of the bonding member 303 of the third embodiment described above. Other configurations of the optical package 400 of the fourth embodiment are similar to the configurations of the optical package 300 of the third embodiment described above.

The bonding member 403 is fixed on the back surface of the mounting substrate 101 and bonded to the frame member 309. The bonding member 403 can be bonded to the frame member 309 at a position protruding from the periphery of the mounting substrate 101. Here, the bonding member 403 can be formed in a frame-like shape so as to protrude from the periphery of the mounting substrate 101. In such a case, the bonding member 403 can be continuously formed in a frame-like shape along the periphery of the mounting substrate 101. A front surface of an outer edge portion of the bonding member 403 can be exposed from the mounting substrate 101.

Thus, in the fourth embodiment described above, the frame member 309 bonded to the bonding member 403 having a frame-like shape and provided on the back surface of the mounting substrate 101 so as to protrude from the periphery of the mounting substrate 101 is disposed from the bonding surface with the glass substrate 106 to the bonding surface with the bonding member 403. This makes it possible to hermetically seal the inside of the optical package 400 while preventing cracking of the glass substrate 106 and to increase the CRA. In such a case, by providing the bonding member 403 having a frame-like shape on the back surface of the mounting substrate 101, it is possible to increase a number of the lead terminals 102 that can be drawn out from the back surface side of the mounting substrate 101 as compared with a case in which the bonding member 303 having a flat plate-like shape is provided on the back surface of the mounting substrate 101.

### 5. Fifth Embodiment

In the third embodiment described above, the frame member 309 bonded to the bonding member 303 provided on the back surface of the mounting substrate 101 so as to protrude from the periphery of the mounting substrate 101 is disposed from the bonding surface with the glass substrate 106 to the bonding surface with the bonding member 303. In this fifth embodiment, the frame member 309 bonded to the bonding member 303 at a position protruding from a periphery of a mounting substrate formed with a cavity is disposed from the bonding surface with the glass substrate 106 to the bonding surface with the bonding member 303.

Fig. 9 is a cross-sectional view depicting a configuration example of an optical package according to the fifth embodiment.

In the drawing, an optical package 500 includes a mounting substrate 501 instead of the mounting substrate 301 of the third embodiment described above. Other configurations of the optical package 500 of the fifth embodiment are similar to the configurations of the optical package 300 of the third embodiment described above.

The mounting substrate 501 is provided with a cavity 502. The image sensor 105 is mounted inside the cavity 502 with the Peltier element 104 interposed therebetween. The image sensor 105 is connected to the mounting substrate 501 via a bonding wire 513. In such a case, a bonding pad connected with the bonding wire 513 can be formed around a periphery of the cavity 502.

Thus, in the fifth embodiment described above, the frame member 309 bonded to the bonding member 303 at a position protruding from the periphery of the mounting substrate 501 formed with the cavity 502 is disposed from the bonding surface with the glass substrate 106 to the bonding surface with the bonding member 303. This makes it possible to hermetically seal the inside of the optical package 500 while preventing cracking of the glass substrate 106 and to increase the CRA. Here, by providing the cavity 502 in the mounting substrate 501, it is possible to reduce a height difference of the bonding wire 513 between the image sensor 105 and the mounting substrate 501.

Further, the bonding wire 513 is connected to the periphery of the cavity 502, and the frame member 309 is disposed between the glass substrate 106 and the bonding member 303. This makes it possible to efficiently release the heat dissipated through the Peltier element 104 from the frame member 309 to the outside while keeping the bonding wire 513 away from the heat dissipation substrate of the Peltier element 104. As a result, it is possible to help prevent the heat dissipated through the Peltier element 104 from flowing back to the image sensor 105 via the bonding wire 513, and suppress a decrease in the cooling efficiency of the image sensor 105.

### 6. Sixth Embodiment

In the fourth embodiment described above, the frame member 309 bonded to the bonding member 403 having a frame-like shape and provided on the back surface of the mounting substrate 101 so as to protrude from the periphery of the mounting substrate 101 is disposed from the bonding surface with the glass substrate 106 to the bonding surface with the bonding member. In this sixth embodiment, a frame member bonded to a bonding member having a frame-like shape and provided on a front surface of the mounting substrate 101 so as to protrude from the periphery of the mounting substrate 101 is disposed from the bonding surface with the glass substrate 106 to a bonding surface with the bonding member.

Fig. 10 is a cross-sectional view depicting a configuration example of an optical package according to the sixth embodiment.

In the drawing, an optical package 600 includes a bonding member 603 and a frame member 609 instead of the bonding member 403 and the frame member 309 of the fourth embodiment described above. Other configurations of the optical package 600 of the sixth embodiment are similar to the configurations of the optical package 400 of the fourth embodiment described above.

The bonding member 603 is fixed on the front surface of the mounting substrate 101 and bonded to the frame member 609. The bonding member 603 can be bonded to the frame member 609 at a position protruding from the periphery of the mounting substrate 101. Here, the bonding member 603 can be configured in a frame-like shape so as to protrude from the periphery of the mounting substrate 101. In such a case, the bonding member 603 can be continuously formed in a frame-like shape along the periphery of the mounting substrate 101. A back surface of an outer edge portion of the bonding member 603 can be exposed from the mounting substrate 101.

The frame member 609 is disposed between the bonding member 603 and the glass substrate 106. In such a case, a lower surface of the frame member 609 is bonded to the bonding member 603, and an upper surface of the frame member 609 is bonded to the glass substrate 106 via the adhesive layer 107. The frame member 609 can be continuously formed in a frame-like shape along a periphery of the bonding member 603. In such a case, the frame member 609 can be disposed spaced apart from the image sensor 105 such that a portion of a side surface of the frame member 609 faces the side surface of the image sensor 105. The welded portion WD can be provided at a bonding position between the frame member 609 and the bonding member 603. A step may be formed on an inner peripheral surface of the frame member 609 to increase the bonding area with the glass substrate 106. To increase the CRA of the optical package 600, the inner peripheral surface of the frame member 609 need not include a step.

Here, a thickness H1 of the frame member 609 can be greater than a thickness H2 of the bonding member 603. This makes it possible to increase the distance between the glass substrate 106 and the welded portion WD. Therefore, damage extending to the glass substrate 106 during welding of the frame member 609 and the bonding member 603 can be reduced, and the buffer member 108 between the glass substrate 106 and the frame member 609 can be omitted. In such a case, the buffer member 108 can be omitted, and the frame member 609 can be disposed from a bonding surface between the glass substrate 106 and the frame member 609 to a bonding surface between the frame member 609 and the bonding member 603. This makes it possible to increase an area of the optical package 600 surrounded by metal and improve the hermeticity of the optical package 600, as compared with a case in which the buffer member 108 is provided.

Thus, in the sixth embodiment described above, the frame member 609 bonded to the bonding member 603 having a frame-like shape and provided on the front surface of the mounting substrate 101 so as to protrude from the periphery of the mounting substrate 101 is disposed from the bonding surface with the glass substrate 106 to the bonding surface with the bonding member 603. This makes it possible to hermetically seal the inside of the optical package 600 while preventing cracking of the glass substrate 106 and to increase the CRA.

Note that, in the embodiments described above, examples are given in which the image sensor 105 is used as the optical element, but an optical element other than the image sensor 105 may be used. For example, the optical element may be a light-receiving element such as a photo diode (PD) or a single photon avalanche diode (SPAD), or may be a light-emitting element such as a laser diode (LD), a light-emitting diode (LED), or a vertical cavity surface-emitting laser (VCSEL) .

Further, in the embodiments described above, examples are given in which the glass substrate 106 is used as the transparent member, but a transparent member other than the glass substrate 106 may be used. For example, a cavity may be formed in the transparent member. Further, the material of the transparent member may be quartz in addition to glass, or Al2O3, CaF2, MgF2, LiF, or the like may be used in accordance with a wavelength detected by the optical element.

### 7. Application Example of Mobile Body

The technology according to the present disclosure (present technology) can be applied to various products. For example, the technology according to the present disclosure may be realized as a device mounted on any type of mobile body such as an automobile, an electric vehicle, a hybrid electric vehicle, a motorcycle, a bicycle, a personal mobility, an airplane, a drone, a ship, and a robot.

Fig. 11 is a block diagram depicting an example of schematic configuration of a vehicle control system as an example of a mobile body control system to which the technology according to an embodiment of the present disclosure can be applied.

The vehicle control system 12000 includes a plurality of electronic control units connected to each other via a communication network 12001. In the example depicted in Fig. 11, the vehicle control system 12000 includes a driving system control unit 12010, a body system control unit 12020, an outside-vehicle information detecting unit 12030, an in-vehicle information detecting unit 12040, and an integrated control unit 12050. In addition, a microcomputer 12051, a sound/image output section 12052, and a vehicle-mounted network interface (I/F) 12053 are illustrated as a functional configuration of the integrated control unit 12050.

The driving system control unit 12010 controls the operation of devices related to the driving system of the vehicle in accordance with various kinds of programs. For example, the driving system control unit 12010 functions as a control device for a driving force generating device for generating the driving force of the vehicle, such as an internal combustion engine, a driving motor, or the like, a driving force transmitting mechanism for transmitting the driving force to wheels, a steering mechanism for adjusting the steering angle of the vehicle, a braking device for generating the braking force of the vehicle, and the like.

The body system control unit 12020 controls the operation of various kinds of devices provided to a vehicle body in accordance with various kinds of programs. For example, the body system control unit 12020 functions as a control device for a keyless entry system, a smart key system, a power window device, or various kinds of lamps such as a headlamp, a backup lamp, a brake lamp, a turn signal, a fog lamp, or the like. In this case, radio waves transmitted from a mobile device as an alternative to a key or signals of various kinds of switches can be input to the body system control unit 12020. The body system control unit 12020 receives these input radio waves or signals, and controls a door lock device, the power window device, the lamps, or the like of the vehicle.

The outside-vehicle information detecting unit 12030 detects information about the outside of the vehicle including the vehicle control system 12000. For example, the outside-vehicle information detecting unit 12030 is connected with an imaging section 12031. The outside-vehicle information detecting unit 12030 makes the imaging section 12031 image an image of the outside of the vehicle, and receives the imaged image. On the basis of the received image, the outside-vehicle information detecting unit 12030 may perform processing of detecting an object such as a human, a vehicle, an obstacle, a sign, a character on a road surface, or the like, or processing of detecting a distance thereto.

The imaging section 12031 is an optical sensor that receives light, and which outputs an electric signal corresponding to a received light amount of the light. The imaging section 12031 can output the electric signal as an image, or can output the electric signal as information about a measured distance. In addition, the light received by the imaging section 12031 may be visible light, or may be invisible light such as infrared rays or the like.

The in-vehicle information detecting unit 12040 detects information about the inside of the vehicle. The in-vehicle information detecting unit 12040 is, for example, connected with a driver state detecting section 12041 that detects the state of a driver. The driver state detecting section 12041, for example, includes a camera that images the driver. On the basis of detection information input from the driver state detecting section 12041, the in-vehicle information detecting unit 12040 may calculate a degree of fatigue of the driver or a degree of concentration of the driver, or may determine whether the driver is dozing.

The microcomputer 12051 can calculate a control target value for the driving force generating device, the steering mechanism, or the braking device on the basis of the information about the inside or outside of the vehicle which information is obtained by the outside-vehicle information detecting unit 12030 or the in-vehicle information detecting unit 12040, and output a control command to the driving system control unit 12010. For example, the microcomputer 12051 can perform cooperative control intended to implement functions of an advanced driver assistance system (ADAS) which functions include collision avoidance or shock mitigation for the vehicle, following driving based on a following distance, vehicle speed maintaining driving, a warning of collision of the vehicle, a warning of deviation of the vehicle from a lane, or the like.

In addition, the microcomputer 12051 can perform cooperative control intended for automated driving, which makes the vehicle to travel automatedly without depending on the operation of the driver, or the like, by controlling the driving force generating device, the steering mechanism, the braking device, or the like on the basis of the information about the outside or inside of the vehicle which information is obtained by the outside-vehicle information detecting unit 12030 or the in-vehicle information detecting unit 12040.

In addition, the microcomputer 12051 can output a control command to the body system control unit 12020 on the basis of the information about the outside of the vehicle which information is obtained by the outside-vehicle information detecting unit 12030. For example, the microcomputer 12051 can perform cooperative control intended to prevent a glare by controlling the headlamp so as to change from a high beam to a low beam, for example, in accordance with the position of a preceding vehicle or an oncoming vehicle detected by the outside-vehicle information detecting unit 12030.

The sound/image output section 12052 transmits an output signal of at least one of a sound and an image to an output device capable of visually or auditorily notifying information to an occupant of the vehicle or the outside of the vehicle. In the example of Fig. 11, an audio speaker 12061, a display section 12062, and an instrument panel 12063 are illustrated as the output device. The display section 12062 may, for example, include at least one of an on-board display and a head-up display.

Fig. 12 is a diagram depicting an example of the installation position of the imaging section 12031.

In Fig. 12, the imaging section 12031 includes imaging sections 12101, 12102, 12103, 12104, and 12105.

The imaging sections 12101, 12102, 12103, 12104, and 12105 are, for example, disposed at positions on a front nose, sideview mirrors, a rear bumper, and a back door of the vehicle 12100 as well as a position on an upper portion of a windshield within the interior of the vehicle. The imaging section 12101 provided to the front nose and the imaging section 12105 provided to the upper portion of the windshield within the interior of the vehicle obtain mainly an image of the front of the vehicle 12100. The imaging sections 12102 and 12103 provided to the sideview mirrors obtain mainly an image of the sides of the vehicle 12100. The imaging section 12104 provided to the rear bumper or the back door obtains mainly an image of the rear of the vehicle 12100. The imaging section 12105 provided to the upper portion of the windshield within the interior of the vehicle is used mainly to detect a preceding vehicle, a pedestrian, an obstacle, a signal, a traffic sign, a lane, or the like.

Incidentally, Fig. 12 depicts an example of photographing ranges of the imaging sections 12101 to 12104. An imaging range 12111 represents the imaging range of the imaging section 12101 provided to the front nose. Imaging ranges 12112 and 12113 respectively represent the imaging ranges of the imaging sections 12102 and 12103 provided to the sideview mirrors. An imaging range 12114 represents the imaging range of the imaging section 12104 provided to the rear bumper or the back door. A bird's-eye image of the vehicle 12100 as viewed from above is obtained by superimposing image data imaged by the imaging sections 12101 to 12104, for example.

At least one of the imaging sections 12101 to 12104 may have a function of obtaining distance information. For example, at least one of the imaging sections 12101 to 12104 may be a stereo camera constituted of a plurality of imaging elements, or may be an imaging element having pixels for phase difference detection.

For example, the microcomputer 12051 can determine a distance to each three-dimensional object within the imaging ranges 12111 to 12114 and a temporal change in the distance (relative speed with respect to the vehicle 12100) on the basis of the distance information obtained from the imaging sections 12101 to 12104, and thereby extract, as a preceding vehicle, a nearest three-dimensional object in particular that is present on a traveling path of the vehicle 12100 and which travels in substantially the same direction as the vehicle 12100 at a predetermined speed (for example, equal to or more than 0 km/hour). Further, the microcomputer 12051 can set a following distance to be maintained in front of a preceding vehicle in advance, and perform automatic brake control (including following stop control), automatic acceleration control (including following start control), or the like. It is thus possible to perform cooperative control intended for automated driving that makes the vehicle travel automatedly without depending on the operation of the driver or the like.

For example, the microcomputer 12051 can classify three-dimensional object data on three-dimensional objects into three-dimensional object data of a two-wheeled vehicle, a standard-sized vehicle, a large-sized vehicle, a pedestrian, a utility pole, and other three-dimensional objects on the basis of the distance information obtained from the imaging sections 12101 to 12104, extract the classified three-dimensional object data, and use the extracted three-dimensional object data for automatic avoidance of an obstacle. For example, the microcomputer 12051 identifies obstacles around the vehicle 12100 as obstacles that the driver of the vehicle 12100 can recognize visually and obstacles that are difficult for the driver of the vehicle 12100 to recognize visually. Then, the microcomputer 12051 determines a collision risk indicating a risk of collision with each obstacle. In a situation in which the collision risk is equal to or higher than a set value and there is thus a possibility of collision, the microcomputer 12051 outputs a warning to the driver via the audio speaker 12061 or the display section 12062, and performs forced deceleration or avoidance steering via the driving system control unit 12010. The microcomputer 12051 can thereby assist in driving to avoid collision.

At least one of the imaging sections 12101 to 12104 may be an infrared camera that detects infrared rays. The microcomputer 12051 can, for example, recognize a pedestrian by determining whether or not there is a pedestrian in imaged images of the imaging sections 12101 to 12104. Such recognition of a pedestrian is, for example, performed by a procedure of extracting characteristic points in the imaged images of the imaging sections 12101 to 12104 as infrared cameras and a procedure of determining whether or not it is the pedestrian by performing pattern matching processing on a series of characteristic points representing the contour of the object. When the microcomputer 12051 determines that there is a pedestrian in the imaged images of the imaging sections 12101 to 12104, and thus recognizes the pedestrian, the sound/image output section 12052 controls the display section 12062 so that a square contour line for emphasis is displayed so as to be superimposed on the recognized pedestrian. The sound/image output section 12052 may also control the display section 12062 so that an icon or the like representing the pedestrian is displayed at a desired position.

An example of the vehicle control system to which the technology according to the present disclosure can be applied has been described above. The technology according to the present disclosure can be applied to the imaging section 12031 and the like among the configurations described above. Specifically, for example, the optical packages of the first to sixth embodiments described above can be applied to the imaging section 12031 and the like. By applying the technology according to the present disclosure to the vehicle control system 12000, it is possible to improve a viewing angle while ensuring a reliability of the imaging section 12031.

Note that the above-described embodiments illustrate examples for embodying the present technology, and the matters in the embodiments have corresponding relations with the matters specifying the invention in the scope of the claims. Similarly, the matters specifying the invention in the scope of the claims have corresponding relations with the matters in the embodiments of the present technology to which the same names are given. However, the present technology is not limited to the embodiments, and can be embodied by applying various modifications to the embodiments without departing from the gist thereof. Further, the effects described in the present specification are merely examples and are not limited, and other effects may be provided.

Note that the present technology can also adopt configurations such as the following.
(1) An optical package including:
   a substrate;
   an optical element mounted on the substrate;
   a transparent member disposed above the optical element, spaced apart from the optical element;
   a frame member fixed to the transparent member; and
   a bonding member fixed to the substrate and bonded to the frame member,
   wherein part of a bonding position between the frame member and the bonding member is located outward of an outer periphery of the substrate.
(2) The optical package according to (1), further including:
   a welded portion provided at the bonding position between the frame member and the bonding member.
(3) The optical package according to (1) or (2),
   wherein a material of the frame member and a material of the bonding member are metal.
(4) The optical package according to any one of (1) to (3),
   wherein the substrate has a flat plate-like shape.
(5) The optical package according to any one of (1) to (4),
   wherein the substrate includes a cavity configured to accommodate the optical element.
(6) The optical package according to any one of (1) to (5),
   wherein the bonding member has a frame-like shape.
(7) The optical package according to any one of (1) to (6),
   wherein the bonding member is disposed on a lower surface of the substrate.
(8) The optical package according to any one of (1) to (7),
   wherein the frame member is disposed spaced apart from the optical element such that part of a side surface of the frame member faces a side surface of the optical element.
(9) The optical package according to any one of (1) to (8),
   wherein the optical element is an image sensor.
(10) The optical package according to any one of (1) to (9), further including:
   a Peltier element provided between the substrate and the optical element.
(11) The optical package according to any one of (1) to (10),
   wherein the frame member is disposed from a bonding surface with the transparent member to a bonding surface with the bonding member.
(12) The optical package according to any one of (1) to (10), further including:
   a buffer member provided in a frame-like shape between the frame member and the transparent member.
(13) The optical package according to (12),
   wherein the buffer member is a ceramic frame.
(14) The optical package according to (12) or (13),
   wherein the frame member is disposed on a lower surface of the buffer member.
(15) The optical package according to any one of (12) to (14),
   wherein the frame member is disposed at a center of a lower surface of the buffer member.
(16) The optical package according to any one of (12) to (15),
   wherein an outer size of the buffer member is larger than an outer size of the substrate.
(17) The optical package according to any one of (12) to (16),
   wherein the buffer member is disposed spaced apart from the optical element such that part of a side surface of the buffer member faces a side surface of the optical element.
(18) A method for manufacturing an optical package, the method including:
   mounting an optical element on a substrate provided with a bonding member at a position protruding from a periphery of the substrate; and
   bonding a frame member provided along a periphery of a transparent member to the bonding member, and disposing the transparent member above the optical element, spaced apart from the optical element.
(19) The method for manufacturing an optical package according to (18),
   wherein a buffer member provided in a frame-like shape is interposed between the frame member and the transparent member.
(20) The method for manufacturing an optical package according to (18) or (19),
   wherein the frame member is bonded to the bonding member on the basis of seam welding.

### Reference Signs List

- 100: Optical package
- 101: Mounting substrate
- 102: Lead terminal
- 103: Bonding member
- 104: Peltier element
- 105: Image sensor
- 106: Glass substrate
- 107: Adhesive layer
- 108: Buffer member
- 109: Frame member
- 111: Drive electrode
- 112: Die bond material
- 113: Bonding wire

## Claims

1. An optical package comprising:
a substrate;
an optical element mounted on the substrate;
a transparent member disposed above the optical element, spaced apart from the optical element;
a frame member fixed to the transparent member; and
a bonding member fixed to the substrate and bonded to the frame member,
wherein part of a bonding position between the frame member and the bonding member is located outward of an outer periphery of the substrate.

2. The optical package according to claim 1, further comprising:
a welded portion provided at the bonding position between the frame member and the bonding member.

3. The optical package according to claim 1,
wherein a material of the frame member and a material of the bonding member are metal.

4. The optical package according to claim 1,
wherein the substrate has a flat plate-like shape.

5. The optical package according to claim 1,
wherein the substrate includes a cavity configured to accommodate the optical element.

6. The optical package according to claim 1,
wherein the bonding member has a frame-like shape.

7. The optical package according to claim 1,
wherein the bonding member is disposed on a lower surface of the substrate.

8. The optical package according to claim 1,
wherein the frame member is disposed spaced apart from the optical element such that part of a side surface of the frame member faces a side surface of the optical element.

9. The optical package according to claim 1,
wherein the optical element is an image sensor.

10. The optical package according to claim 1, further comprising:
a Peltier element provided between the substrate and the optical element.

11. The optical package according to claim 1,
wherein the frame member is disposed from a bonding surface with the transparent member to a bonding surface with the bonding member.

12. The optical package according to claim 1, further comprising:
a buffer member provided in a frame-like shape between the frame member and the transparent member.

13. The optical package according to claim 12,
wherein the buffer member is a ceramic frame.

14. The optical package according to claim 12,
wherein the frame member is disposed on a lower surface of the buffer member.

15. The optical package according to claim 12,
wherein the frame member is disposed at a center of a lower surface of the buffer member.

16. The optical package according to claim 12,
wherein an outer size of the buffer member is larger than an outer size of the substrate.

17. The optical package according to claim 12,
wherein the buffer member is disposed spaced apart from the optical element such that part of a side surface of the buffer member faces a side surface of the optical element.

18. A method for manufacturing an optical package, the method comprising:
mounting an optical element on a substrate provided with a bonding member at a position protruding from a periphery of the substrate; and
bonding a frame member provided along a periphery of a transparent member to the bonding member, and disposing the transparent member above the optical element, spaced apart from the optical element.

19. The method for manufacturing an optical package according to claim 18,
wherein a buffer member provided in a frame-like shape is interposed between the frame member and the transparent member.

20. The method for manufacturing an optical package according to claim 18,
wherein the frame member is bonded to the bonding member on the basis of seam welding.
